(19) Europäisches Patentamt
European Patent Office
Office européen des brevets

(11) **EP 2 199 436 A1**

(12) **EUROPEAN PATENT APPLICATION**
published in accordance with Art. 153(4) EPC

(43) Date of publication:
**23.06.2010 Bulletin 2010/25**

(51) Int Cl.:
***C30B 29/38*** *(2006.01)*    ***C30B 25/18*** *(2006.01)*
***H01L 21/205*** *(2006.01)*    ***H01S 5/323*** *(2006.01)*
***H01S 5/343*** *(2006.01)*

(21) Application number: **08835691.0**

(22) Date of filing: **19.09.2008**

(86) International application number:
**PCT/JP2008/066945**

(87) International publication number:
**WO 2009/044638 (09.04.2009 Gazette 2009/15)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **04.10.2007 JP 2007261198**

(71) Applicant: **Sumitomo Electric Industries, Ltd.**
**Chuo-ku**
**Osaka-shi**
**Osaka 540-0041 (JP)**

(72) Inventors:
• **NAKAHATA, Seiji**
  **Itami-shi**
  **Hyogo 664-0016 (JP)**
• **MOTOKI, Kensaku**
  **Itami-shi**
  **Hyogo 664-0016 (JP)**

(74) Representative: **Grünecker, Kinkeldey,**
**Stockmair & Schwanhäusser**
**Anwaltssozietät**
**Leopoldstrasse 4**
**80802 München (DE)**

(54) **GAN EPITAXIAL SUBSTRATE, SEMICONDUCTOR DEVICE AND METHODS FOR MANUFACTURING GAN EPITAXIAL SUBSTRATE AND SEMICONDUCTOR DEVICE**

(57)    Affords GaN epitaxial wafers designed to improve production yields, as well as semiconductor devices utilizing such GaN epitaxial wafers, and methods of manufacturing such GaN epitaxial wafers and semiconductor devices.

A GaN epitaxial wafer manufacturing method involving the present invention includes a first GaN layer formation step of epitaxially growing a first GaN layer onto a substrate, a pit formation step, following the first GaN layer formation step, of forming pits in the front side of the substrate, and a second GaN layer formation step, following the pit-formation step, of epitaxially growing a second GaN layer onto the first GaN layer, and therefore controls cracking to a minimum and improves production yields.

FIG. 1A

10

FIG. 1B

FIG. 1C

FIG. 1D

**Description**

<u>Technical Field</u>

The present invention relates to GaN epitaxial wafers and semiconductor devices, and to methods of manufacturing GaN epitaxial wafers and semiconductor devices.

<u>Background Art</u>

In order to improve light-emitting efficiency and other microelectronic element properties in the fabrication of semiconductor devices such as LEDs, monocrystalline GaN wafers have conventionally been employed. The below-referenced Patent Document 1, for example, discloses a method of producing a wafer of GaN single crystal by growing a ZnO layer onto a substrate of a high-quality material such as sapphire, and thereafter changing the crystallographic polarity of the ZnO layer and growing on it a GaN single crystal and then dissolving off the ZnO layer.

*Patent Document 1:* Japanese Unexamined Pat. App. Pub. No. 2004-284831

<u>Disclosure of Invention</u>

*Problem Intention Is to Solve*

When monocrystalline GaN wafers are employed to attempt to fabricate semiconductor devices, however, the following problem occurs. Namely, in the process of growing epitaxial layers onto single-crystal wafers and in the process of singulating the semiconductor devices after epitaxial-layer formation, cracks are likely to occur in the epitaxial layers and single-crystal wafers. In employing single-crystal wafers to fabricate semiconductor devices, the occurrence of faults is thus frequent, such that production yields have not necessarily been high.

An object of the present invention, brought about taking the above into consideration, is to make available GaN epitaxial wafers designed to improve production yields, as well as semiconductor devices utilizing such GaN epitaxial wafers, and methods of manufacturing such GaN epitaxial wafers and semiconductor devices.

*Means for Resolving the Problem*

In order to achieve the above object, a GaN epitaxial wafer of the present invention is characterized in including: a first GaN layer formation step of epitaxially growing a first GaN layer onto a substrate; a pit formation step, following the first GaN layer formation step, of forming pits in the front side of the substrate; and a second GaN layer formation step, following the pit-formation step, of epitaxially growing a second GaN layer onto the first GaN layer.

According to the foregoing manufacturing method, forming pits in the front side of the substrate after epitaxially growing a first GaN layer onto the substrate alters the growth direction of the first GaN layer in the proximity of the pits. Because the first GaN layer growth direction in the other regions does not alter, areas appear where the growth direction differs from the growth direction that the first GaN layer epitaxially grown at the beginning possesses, bringing about a state in which zones having a plurality of growth directions exist within the first GaN layer. When the second GaN layer is thereafter epitaxially grown onto the first GaN layer having a plurality of growth directions, the GaN layer where the growth direction differs grows as different crystal, whereby a GaN epitaxial wafer having a polycrystalline GaN layer is fabricated.

The present inventors, capping intensive research efforts, discovered that utilizing GaN epitaxial wafers obtained by the present manufacturing method to fabricate semiconductor devices made it possible to reduce the above-described occurrence of cracking in the epitaxial layers and in the wafers, enabling improvement in production yields in the fabrication of semiconductor devices to be realized.

A GaN epitaxial wafer manufacturing method of the present invention may be conditioned by having a mask-layer formation step, prior to the first GaN layer formation step, of patterning a mask layer onto the front side of the substrate.

A GaN epitaxial wafer manufacturing method of the present invention may also be conditioned by the substrate being constituted by a single layer. In that case, in the pit formation step the pits are formed onto the single-layer substrate.

The method alternatively may be conditioned by the substrate being constituted by a plurality of layers, wherein in the pit formation step the pits are formed on the uppermost layer of the substrate. According to these terms, the materials that may be selected for the substrate multiply. GaN epitaxial wafers involving the present invention can therefore be fabricated under broader-ranging production requisites.

In a semiconductor device manufacturing method of the present invention, included are: a first GaN layer formation step of epitaxially growing a first GaN layer onto a substrate; a pit formation step, following the first GaN layer formation step, of forming pits in the front side of the substrate; a second GaN layer formation step, following the pit-formation step, of epitaxially growing a second GaN layer onto the first GaN layer to fabricate a GaN epitaxial wafer; and a device manufacturing step of utilizing the GaN epitaxial wafer to fabricate semiconductor devices.

In this implementation, forming pits in the front side of the substrate after growing a first GaN layer onto the substrate alters the growth direction of the first GaN layer in the proximity of the pits. Because the first GaN layer growth direction in the other regions does not alter, areas appear having a growth direction that differs from the growth direction of the first GaN layer epitaxially grown at the beginning, bringing about a state in which zones that possess a plurality of growth directions exist within the first GaN layer. Utilizing to fabricate semiconductor devices the GaN epitaxial wafer obtained by thereafter epitaxially growing the second GaN layer onto the first GaN layer having a plurality of growth directions makes it possible to reduce incidents of cracking in fabricating the semiconductor devices, enabling improvement in production yields to be realized.

A semiconductor device manufacturing method of the present invention may also include a mask-layer formation step, prior to the first GaN layer formation step, of patterning a mask layer onto the front side of the substrate.

In a semiconductor device manufacturing method of the present invention, the substrate may be constituted by a single layer.

A semiconductor device manufacturing method of the present invention alternatively may be conditioned by the substrate being constituted by a plurality of layers, wherein in the pit formation step the pits are formed on the uppermost layer of the substrate.

Furthermore, a semiconductor device manufacturing method of the present invention may be conditioned by, for the device manufacturing step, utilizing to fabricate the semiconductor devices a GaN wafer obtained by removing the substrate from the GaN epitaxial wafer. Not using the substrate in the semiconductor devices lessens the restrictions on the material selected for the substrate, making it possible to employ a wider range of materials for the substrate. What is more, the fact that in the semiconductor devices only layers composed of polycrystalline GaN laminae are utilized enables semiconductor devices of superior device properties to be obtained, which can serve to further improve production yields.

A GaN epitaxial wafer of the present invention is characterized in being furnished with a substrate having pits in the major surface, and a polycrystalline GaN layer layered onto the major surface. The fact that the GaN layer laminated onto the major surface of the substrate is polycrystalline makes it possible to minimize the occurrence of cracking in semiconductor device fabrication, which can serve to further improve production yields.

A GaN epitaxial wafer of the present invention also may be furnished with a mask layer, disposed in between the substrate and the polycrystalline GaN layer.

A GaN epitaxial wafer of the present invention may also be conditioned by the substrate being constituted by a single layer.

A GaN epitaxial wafer of the present invention alternatively may be conditioned by the substrate being constituted by a plurality of layers, and therein by having the pits in the uppermost layer of the substrate.

Semiconductor devices of the present invention are characterized by having a substrate that has pits in its major surface, a GaN epitaxial wafer that has a polycrystalline GaN layer layered onto the major surface, and a semiconductor layer layered onto the polycrystalline GaN layer on the GaN epitaxial wafer. Accordingly, the fact that the GaN layer laminated onto the major surface of the substrate is polycrystalline minimizes incidents of cracking during semiconductor device fabrication, thus serving to improve production yields.

*Effects of the Invention*

The present invention makes available GaN epitaxial wafers serving to improve production yields, and also affords semiconductor devices utilizing the GaN epitaxial wafers, and methods of manufacturing the GaN epitaxial wafers and the semiconductor devices.

Fig. 1A is diagram for illustrating a method of manufacturing a GaN epitaxial wafer 51 involving Embodying Mode 1 of the present invention.
Fig. 1B is diagram for illustrating a method of manufacturing a GaN epitaxial wafer 51 involving Embodying Mode 1 of the present invention.
Fig. 1C is diagram for illustrating a method of manufacturing a GaN epitaxial wafer 51 involving Embodying Mode 1 of the present invention.
Fig. 1D is diagram for illustrating a method of manufacturing a GaN epitaxial wafer 51 involving Embodying Mode 1 of the present invention.
Fig. 2A is a diagram schematically illustrating a peak obtained when a conventional example of a monocrystalline GaN wafer 50 and a GaN epitaxial wafer 51 involving Embodying Mode 1 of the present invention were XRD analyzed.

Fig. 2B is a diagram schematically illustrating peaks obtained when a conventional example of a monocrystalline GaN wafer 50 and a GaN epitaxial wafer 51 involving Embodying Mode 1 of the present invention were XRD analyzed.

Fig. 3A is diagram for illustrating a method of manufacturing a GaN epitaxial wafer 52 involving Embodying Mode 2 of the present invention.

Fig. 3B is diagram for illustrating a method of manufacturing a GaN epitaxial wafer 52 involving Embodying Mode 2 of the present invention.

Fig. 3C is diagram for illustrating a method of manufacturing a GaN epitaxial wafer 52 involving Embodying Mode 2 of the present invention.

Fig. 3D is diagram for illustrating a method of manufacturing a GaN epitaxial wafer 52 involving Embodying Mode 2 of the present invention.

Fig. 4 is a diagram showing a pattern for patterning with an $SiO_2$ film, employed in methods of the present invention of manufacturing a GaN epitaxial wafer 52 involving Embodying Mode 2, and GaN epitaxial wafer 54 involving Embodying Mode 4

Fig. 5A is diagram for illustrating a method of manufacturing a GaN epitaxial wafer 53 involving Embodying Mode 3 of the present invention.

Fig. 5B is diagram for illustrating a method of manufacturing a GaN epitaxial wafer 53 involving Embodying Mode 3 of the present invention.

Fig. 5C is diagram for illustrating a method of manufacturing a GaN epitaxial wafer 53 involving Embodying Mode 3 of the present invention.

Fig. 5D is diagram for illustrating a method of manufacturing a GaN epitaxial wafer 53 involving Embodying Mode 3 of the present invention.

Fig. 6A is diagram for illustrating a method of manufacturing a GaN epitaxial wafer 54 involving Embodying Mode 4 of the present invention.

Fig. 6B is diagram for illustrating a method of manufacturing a GaN epitaxial wafer 54 involving Embodying Mode 4 of the present invention.

Fig. 6C is diagram for illustrating a method of manufacturing a GaN epitaxial wafer 54 involving Embodying Mode 4 of the present invention.

Fig. 6D is diagram for illustrating a method of manufacturing a GaN epitaxial wafer 54 involving Embodying Mode 4 of the present invention.

Fig. 7 is a diagram of a semiconductor device 110 involving Embodying Mode 5 of the present invention.

Fig. 8A is a diagram of a semiconductor device 120 involving Embodying Mode 6 of the present invention.

Fig. 8B is a diagram of a semiconductor device 120 involving Embodying Mode 6 of the present invention.

Fig. 9 is a diagram of a semiconductor device 130 involving Embodying Mode 7 of the present invention.

Fig. 10 is a diagram of a semiconductor device 140 involving Embodying Mode 8 of the present invention.

Fig. 11 is a diagram of a semiconductor device 150 involving Embodying Mode 9 of the present invention.

Fig. 12 is a diagram illustrating points for analyzing diffraction patterns from a GaN wafer in an XRD determination.

Fig. 13 is an example of an XRD pattern recorded in the XRD determination at one of the analysis points.

*Legend*

| 1: | GaN wafer |
|---|---|
| 10, 20, 30A 40A: | substrate |
| 51, 52, 53, 54: | GaN epitaxial wafer |
| 110: | semiconductor device (LED) |
| 120: | semiconductor device (LD) |
| 130: | semiconductor device (HEMT) |
| 140: | semiconductor device (Schottky diode) |
| 150: | semiconductor device (vertical MIS transistor) |

Best Mode for Carrying Out the Invention

Hereinafter, referring to the accompanying drawings, an explanation of embodiments of the present invention will be made in detail. It should be understood that in describing the drawings, with the same reference marks being used for identical or equivalent features, reduplicating description will be omitted.

Embodying Mode 1

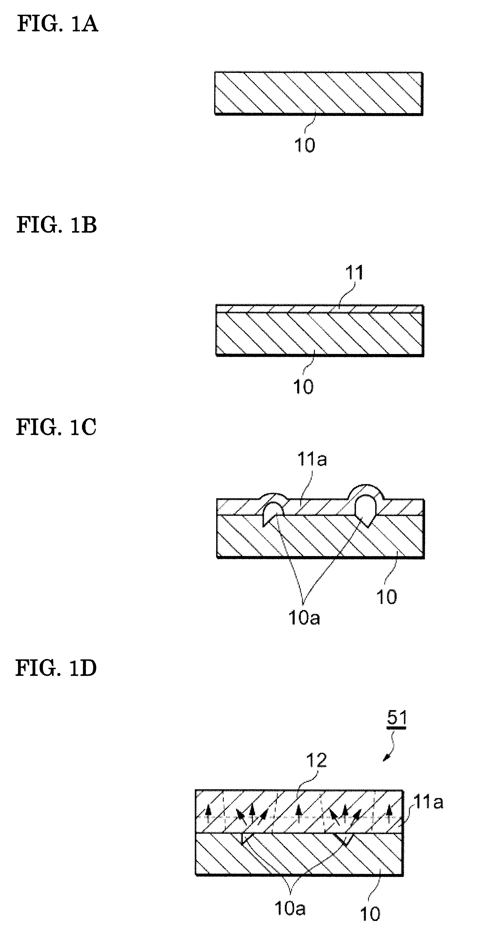

Fig. 1 is diagrams for illustrating a method of manufacturing a GaN epitaxial wafer 51 involving Embodying Mode 1 of the present invention. Included by a method, involving the present embodying mode, of manufacturing a GaN epitaxial wafer 50 are:

(1) As indicated in Figs. 1A and 1B, a first GaN layer formation step of epitaxially growing a first GaN layer 11 onto a substrate 10;
(2) As indicated in Fig. 1C, a pit formation step, following the first GaN layer formation step, of forming pits 10a in the front side of the substrate 10; and
(3) As indicated in Figs. 1C and 1D, a second GaN layer growth step, following the pit-formation step, of epitaxially growing a second GaN layer 12 onto the first GaN layer 11a, having been transformed by the pit formation step. In the following, each of the foregoing manufacturing process steps will be explained in detail.

To begin with, a single-crystal substrate 10, represented in Fig. 1A, is prepared. InP, GaAs, GaP, GaN, AlN or a like material is preferable for the substrate 10. These semiconductor materials facilitate the formation of pits in the pit formation step, making them ideally suited as substrates involving the present embodying mode.

Next, as the first GaN layer formation step, a first GaN layer 11 is epitaxially grown onto the substrate 10, as indicated in Fig. 1B. For the method of growing the first GaN layer 11, it is for example by a technique such as hydride or halide vapor phase epitaxy (HVPE). The thickness is approximately 1 $\mu$m.

Subsequently, as the pit formation step, pits 10a are formed in the front side of the substrate 10, as indicated in Fig. 1C. The means whereby the pits are formed may be, to cite examples, a method whereby the substrate 10 to be provided with the first GaN layer 11 thereon is taken out of the growth reactor and etched with $NH_3$ or a like solution that is corrosive, a method whereby the substrate is etched within the growth reactor using HCl gas or $NH_3$ gas, or a method whereby the substrate is heated. A specific example is a method whereby HCl gas is flowed under a temperature of 800°C to carry out etching. These operations form pits 10a in the front side of the substrate 10, as indicated in Fig. 1C, and at the same time the first GaN layer itself, by the etching and heating, turns into a first GaN layer 11a in which the epitaxial layer-especially the areas where it covers the front side of the pits 10a-has been spot-transformed.

When GaN further grows epitaxially onto the front side of the first GaN layer 11a, a second GaN layer 12, as illustrated in Fig. 1D, forms. As the second GaN layer formation step, in Fig. 1D, a second GaN layer 12 is epitaxially grown onto the front side of the first GaN layer 11a. The second GaN layer 12 is thereby formed as a polycrystalline layer. In Fig. 1D the arrows within the first GaN layer 11a and second GaN layer 12 schematically represent crystal-growth directions. In the GaN epitaxial wafer thus obtained, pits 10a in between the substrate 10 and the first GaN layer 11a, as indicated in Fig. 1D, will remain.

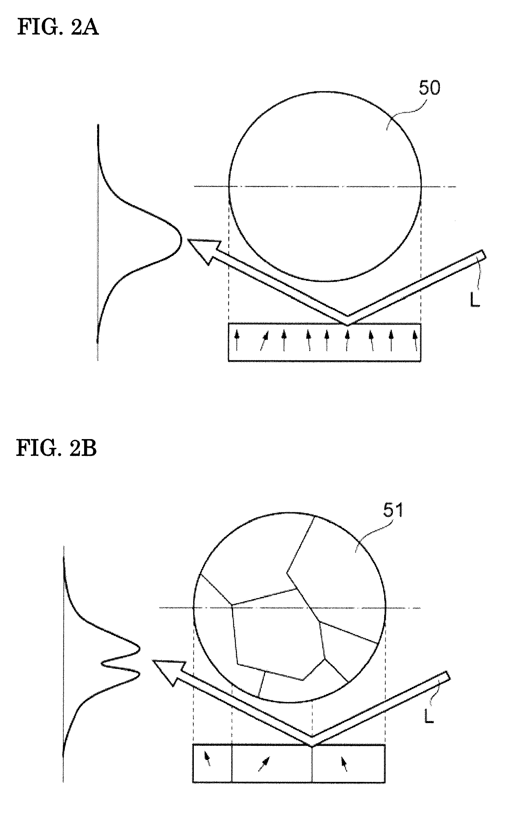

The crystal structure of the GaN epitaxial wafer 51 obtained in the manner set forth above will now be described, in comparison with a conventional, monocrystalline GaN wafer. Fig. 2 is diagrams schematically illustrating peaks obtained when a conventional example of a monocrystalline GaN wafer 50 and a GaN epitaxial wafer 51 involving Embodying Mode 1 of the present invention were XRD analyzed. Fig. 2A is the instance with the monocrystalline GaN wafer 50, and Fig. 2B is the instance with the GaN epitaxial wafer 51 obtained according to Embodying Mode 1. Included in each drawing is a figure schematically representing the surface of the crystal wafer, a sectional view (with the arrows indicating crystal-growth directions) through the center-line portion of the figure, and an example of an x-ray diffraction pattern obtained when a beam of x-rays was directed onto the crystal.

Given that the monocrystalline GaN wafer 50 is monocrystalline, its growth directions also, as indicated in Fig. 2A (the arrows in the figure), are essentially in a singular orientation. When an x-ray beam L strikes the front side of the crystal, the beam L is reflected by a crystallographic plane possessing the singularly oriented growth direction (crystal orientation), and therefore a singular peak is obtained. In the case of a GaN epitaxial wafer 51 involving Embodying Mode 1, however, as indicated in Fig. 2B, grain boundaries (or otherwise, interfaces that are like low-angle grain boundaries) are present, and along the grain boundaries the crystal growth direction changes. When an x-ray beam L strikes the crystal in the vicinity of a grain boundary, because the beam L is reflected by a plurality of (two) crystallographic planes, the crest in the XRD pattern obtained is split into a plurality of (two) peaks. Thus, when an x-ray beam is directed onto the polycrystal wafer, owing to the fact that the crystal growth directions each differ, split peaks are seen.

The present inventors discovered that utilizing a GaN epitaxial wafer composed of a GaN polycrystal in which split peaks are characterized in its XRD pattern, as sketched in Fig. 2B, to fabricate semiconductor devices makes it possible to reduce the incidence of cracking during semiconductor device fabrication, enabling improved production yields to be realized, by comparison with the situation in which devices are fabricated using a GaN single crystal like that represented in Fig. 2A. The causative factors behind this are believed to be as follows.

To begin with, strain can be considered to be a cause of cracking. Specifically, when semiconductor devices are fabricated using a monocrystalline GaN wafer as the foundation, epitaxial layers whose composition differs, or whose impurity level differs, from that of GaN are formed onto the substrate. The lattice constants and thermal expansion coefficients in the monocrystalline GaN wafer and the epitaxial layers therefore do not agree, owing to which in the midst of formation or following formation of the epitaxial layer, strain occurs at the interface between the wafer and epitaxial layers. The strain causes cracking.

Furthermore, another cause of cracking is believed to be that when thermal or mechanical external forces are imparted in the course of cooling the epitaxial layers after they have been formed-and further, during post-formation back side processing of the epitaxial layers and in the dicing process-cracking is likely to occur.

Yet in instances in which the GaN wafer has grain boundaries, as in the present embodying mode, the grain boundaries are believed to act as a cushioning element (function as a buffer). Specifically, it is believed that a phenomenon obtains whereby for example when strain is produced in a GaN wafer, dislocations multiply at the grain boundaries, where crystal defects are largely incorporated, mitigating the strain, or the crystal slips along the crystal defects, mitigating the strain. Accordingly, fabricating semiconductor devices utilizing a GaN epitaxial wafer constituted by polycrystal GaN in the manner of the present embodying mode is thought to make it possible to obtain the devices at, with a low incidence of cracking, high production yields.

Embodying Mode 2

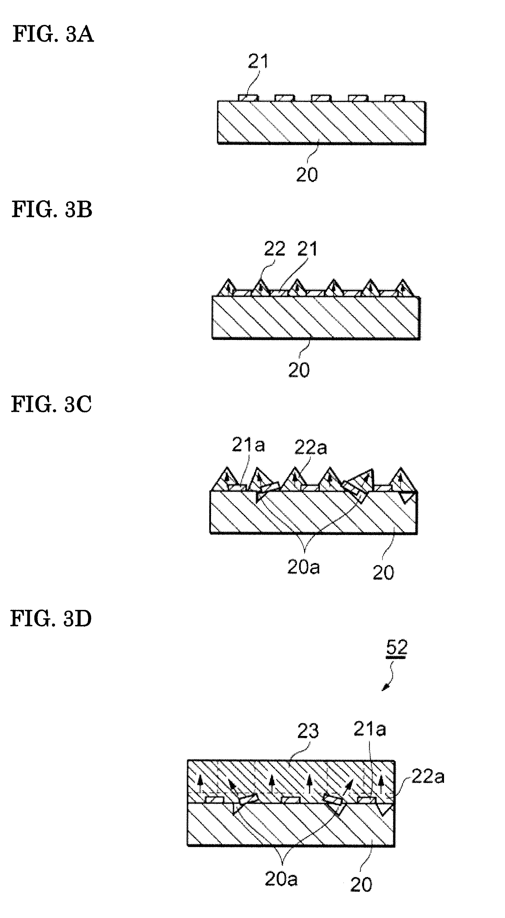

Fig. 3 is diagrams for illustrating a method of manufacturing a GaN epitaxial wafer 52 involving Embodying Mode 2 of the present invention. Included by a method, involving the present embodying mode, of manufacturing a GaN epitaxial wafer 52 are:

(1) As indicated in Fig. 3A, a mask-layer formation step of patterning a mask layer 21 onto the front side of a substrate 20;
(2) As indicated in Fig. 3B, a first GaN layer formation step of epitaxially growing a first GaN layer 22 onto the front side of the substrate 20 on which the mask layer 21 has been formed;
(3) As indicated in Fig. 3C a pit formation step, following the first GaN layer formation step, of forming pits 20a in the front side of the substrate 20; and
(4) As indicated in Figs. 3C and 3D, a second GaN layer formation step, following the pit-formation step, of forming a second GaN layer 23 onto the mask layer 21a and first GaN layer 22a, having been transformed by the pit formation step.

In the following, each of the foregoing manufacturing process steps will be explained in detail while making a comparison with Embodying Mode 1.

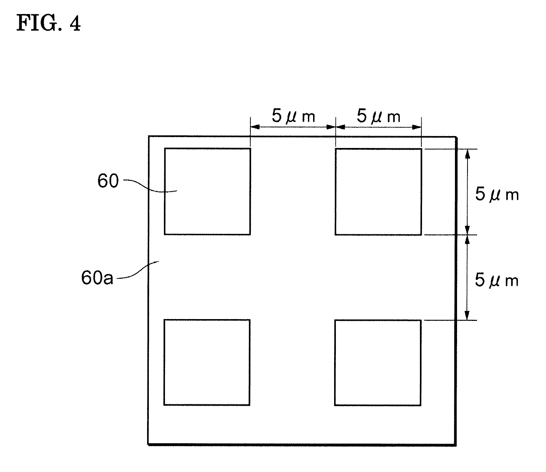

A method, involving Embodying Mode 2, of manufacturing a GaN epitaxial wafer 52 differs compared with Embodying Mode 1, in the respect that as a mask-layer formation step a mask layer 21 is patterned onto the front side of the substrate 20. As the mask layer 21 an $SiO_2$ film, for example, is ideally suitable. And the method whereby the mask layer is patterned may be a general formation technique. As a specific example, an $SiO_2$ film may be applied over the entire surface, after which a mask layer 21, as indicated in Fig. 4, is obtained by performing a photolithographic process in a manner such that squares 60, 5 $\mu$m to a side, form a matrix array at a 5 $\mu$m spacing 60a.

Thus, with an implementation in which the mask layer 21 is formed on the front side of the substrate 20, when pits 20a are formed in the front side of the substrate 20, as illustrated in Fig. 3C, with the first GaN layer 22 spot-transforming over the pits 20a, in a like manner as in Embodying Mode 1, the growth directions in those areas change, resulting in a first GaN layer 22a containing grain boundaries. At the same time, as the pits are formed the mask layer 21 inclines, as represented in Fig. 3C, turning into a displaced mask layer 21a. Onto a mask layer 21a of such form, in the succeeding step of creating the second GaN layer 23, the GaN grows epitaxially in directions that differ from the initial growth direction. A GaN epitaxial wafer incorporating a second GaN layer 23 that is a polycrystalline layer can thereby be produced.

In Embodying Mode 2, similarly as in Embodying Mode 1, a GaN epitaxial wafer 52 incorporating a polycrystalline GaN layer can be produced as described above. Then utilizing the GaN epitaxial wafer 52 to fabricate semiconductor devices enables the devices to be obtained with minimal occurrence of cracks, for high production yields.

Embodying Mode 3

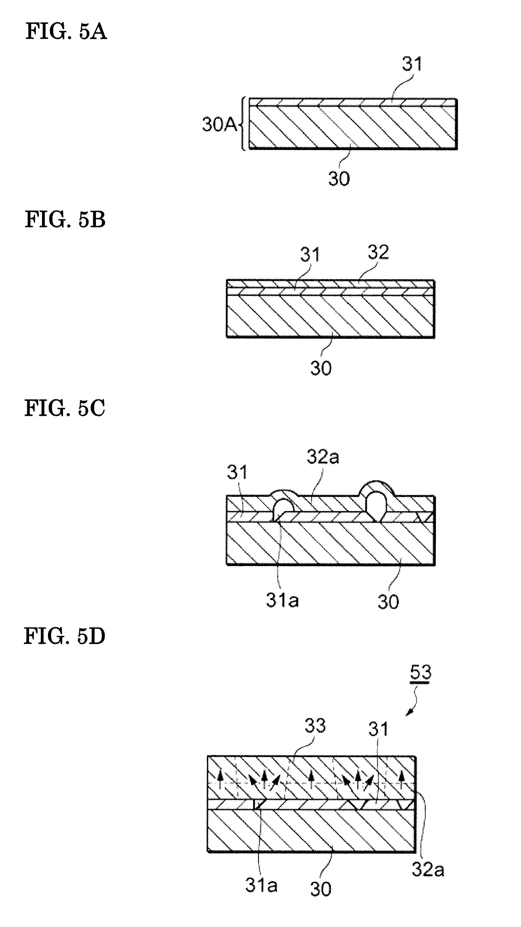

Fig. 5 is diagrams for illustrating a method of manufacturing a GaN epitaxial wafer 53 involving Embodying Mode 3 of the present invention. Included by a method, involving the present embodying mode, of manufacturing a GaN epitaxial wafer 53 are:

(1) As indicated in Figs. 5A and 5B, a first GaN layer formation step of epitaxially growing a first GaN layer 32 onto the front side of a second substrate layer 31 on a substrate 30A composed of two layers-a first substrate layer 30 and the second substrate layer 31, on the front side of the first substrate layer 30;

(2) As indicated in Fig. 5C, a pit formation step, following the first GaN layer formation step, of forming pits 31a in the front side of the second substrate layer 31 (the uppermost layer of the substrate); and

(3) As indicated in Figs. 5C and 5D, a second GaN layer growth step, following the pit-formation step, of epitaxially growing a second GaN layer 33 onto the first GaN layer 32a, having been transformed by the pit formation step. In the following, each of the foregoing manufacturing process steps will be explained in detail while making a comparison with Embodying Mode 1 and Embodying Mode 2.

A method, involving Embodying Mode 3, of manufacturing a GaN epitaxial wafer 53 differs from Embodying Mode 1 and Embodying Mode 2 in the respect that the substrate 30A is composed of a plurality of layers. With an implementation in which the substrate 30A is made a plurality of layers, in the pit formation step in the present embodying mode, the pits are formed in the second substrate layer 31, which is the uppermost layer of the substrate. As the semiconductor material utilized for the second substrate layer 31, compounds such as InP, GaAs, GaP, GaN and AlN, which facilitate the forming of pits in the pit formation step, are preferable. Also, in the present embodying mode the material utilized as the first substrate layer 30 is not limited to the just-mentioned InP, GaAs, GaP, GaN, AlN and the like; materials such as sapphire substrates, for example, that do not corrode easily under etching or a like process can be utilized. An example of a specific technique whereby the second substrate layer 31 is formed onto the first substrate layer 30 is a method whereby a (0001) *c*-plane sapphire substrate top is readied as the first substrate layer 30, onto which a GaN crystal layer is grown using the metalorganic chemical vapor deposition (MOCVD) technique to form the second substrate layer 31.

In accordance with Embodying Mode 3 as just described, a GaN epitaxial wafer 53 incorporating a polycrystalline GaN layer can be produced. Then utilizing the GaN epitaxial wafer 53 to fabricate semiconductor devices enables the devices to be obtained with minimal occurrence of cracks, for high production yields. Furthermore, according to the present embodying mode, the fact that the substrate 30A is made up of a plurality of layers increases the choice of materials utilized for substrate 30A, enabling the GaN epitaxial wafer 53 to be produced under a broader range of manufacturing conditions.

Embodying Mode 4

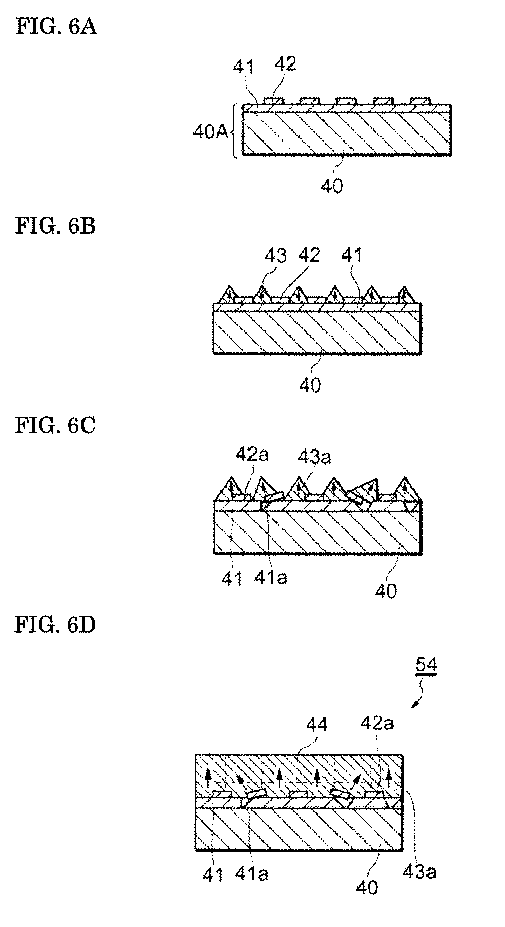

Fig. 6 is diagrams for illustrating a method of manufacturing a GaN epitaxial wafer 54 involving Embodying Mode 4 of the present invention. Included by a method, involving the present embodying mode, of manufacturing a GaN epitaxial wafer 54 are:

(1) As indicated in Fig. 6A, a mask-layer formation step of patterning a mask layer 42 onto the front side of a substrate 40A composed of two layers-a first substrate layer 40 and a second substrate layer 41 on the front side of the first substrate layer 40;

(2) As indicated in Fig. 6B, a first GaN layer formation step of epitaxially growing a first GaN layer 43 onto the front side of the second substrate layer 41 on which the mask layer 42 has been formed;

(3) As indicated in Fig. 6C a pit formation step, following the first GaN layer formation step, of forming pits 41a in the front side of the second substrate layer 41 (the uppermost layer of the substrate); and

(4) As indicated in Figs. 6C and 6D, a second GaN layer growth step, following the pit-formation step, of epitaxially growing a second GaN layer 44 onto the first GaN layer 43a, having been transformed by the pit formation step.

In the following, each of the foregoing manufacturing process steps will be explained in detail while making a comparison with Embodying Mode 1 through Embodying Mode 3.

A method, involving Embodying Mode 4, of manufacturing a GaN epitaxial wafer 54 is similar to Embodying Mode 3 in the respect that the substrate 40A is made up of a plurality of layers.
The present embodying mode is further characterized in having, similar to Embodying Mode 2, a mask-layer formation step, prior to the first GaN layer growth step, of patterning a mask layer 42.

In accordance with Embodying Mode 4 as just described, a GaN epitaxial wafer 54 incorporating a polycrystalline GaN layer can be produced. Then utilizing the GaN epitaxial wafer 54 to fabricate semiconductor devices enables the devices to be obtained with minimal occurrence of cracks, for high production yields. Furthermore, according to the present embodying mode, the fact that the substrate 40A is made up of a plurality of layers increases the choice of materials utilized for substrate 40A, enabling the GaN epitaxial wafer 54 to be produced under a broader range of manufacturing conditions.

The GaN epitaxial wafers 51 through 54 obtained according to Embodying Mode 1 through Embodying Mode 4 can be utilized without modification to fabricate semiconductor devices. Alternatively, as needed the laminar part consisting of the first GaN layer and second GaN layer can be separated from the substrate 10, 20, 30A or 40A and utilized as a polycrystalline GaN wafer in the manufacture of semiconductor devices. When a wafer obtained by separating the substrates 10, 20, 30A or 40A from GAN epitaxial wafers 51 through 54 is used as the GAN wafer from which semiconductor device with a high performance is made, because the device is provided with only a layer composed of GAN.

In the following semiconductor-device embodying modes involving the present invention, semiconductor devices utilizing polycrystalline GaN wafers 1, obtained by separating the substrates 10, 20, 30A and 40A from the GaN epitaxial wafers 51 through 54 produced according to Embodying Mode 1 through Embodying Mode 4, will be described.

Embodying Mode 5

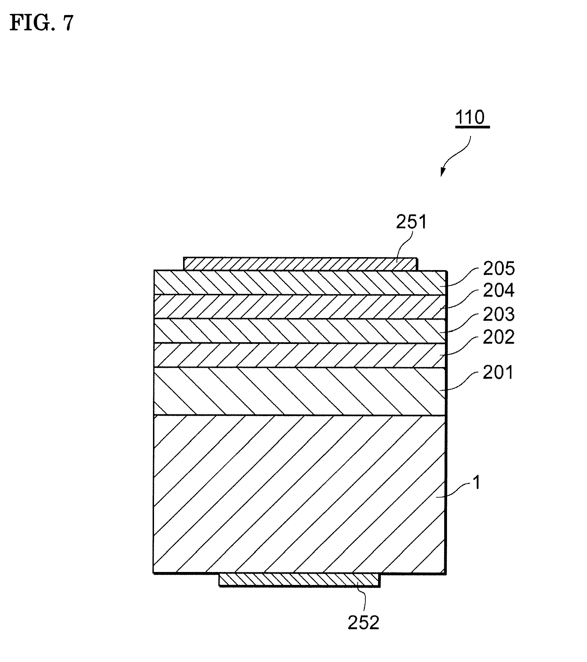

Fig. 7 is a diagram of a semiconductor device 110 involving Embodying Mode 5 of the present invention. As shown in Fig. 7, the semiconductor device 110 involving the present embodying mode is composed of: a semiconductor laminar structure in which are formed, in order on the front side of a GaN wafer 1, an $n$-type GaN layer 201, an $n$-type AlGaN layer 202, a light-emitting layer 203, a $p$-type AlGaN layer 204, and a $p$-type GaN layer 205; a $p$-electrode 251 on the front side of the $p$-type GaN layer 206; and an $n$-electrode 252 on the back side of the GaN wafer 1. This semiconductor device 110 functions as a light-emitting diode (LED).

The light-emitting layer 203 may be a multiquantum-well (MQW) structure-for example, in which a bilaminar GaN-layer and $In_{0.2}Ga_{0.8}N$-layer structure is stacked multi-tiered.

The semiconductor device 110 of the present embodying mode is fabricated by the following method for example. To begin with, for the device manufacturing step, the $n$-type GaN layer 201, the $n$-type AlGaN layer 202, the light-emitting layer 203, the $p$-type AlGaN layer 204, and the $p$-type GaN layer 205 are formed, in order, by MOCVD onto the front side of the GaN wafer 1. Subsequently, the $p$-electrode 251, at a thickness of 100 nm, is formed onto the front side of the $p$-type GaN layer 205. Further, the $n$-electrode 252 is formed on the back side of the GaN wafer 1, thereby yielding an LED-i.e., semiconductor device 110.

In accordance with Embodying Mode 5 as just described, utilizing a polycrystalline-GaN-layer- incorporating GaN epitaxial wafer to fabricate a semiconductor device makes it possible to produce a semiconductor device (LED) in which cracking is minimal and the yield rate is superior.

Embodying Mode 6

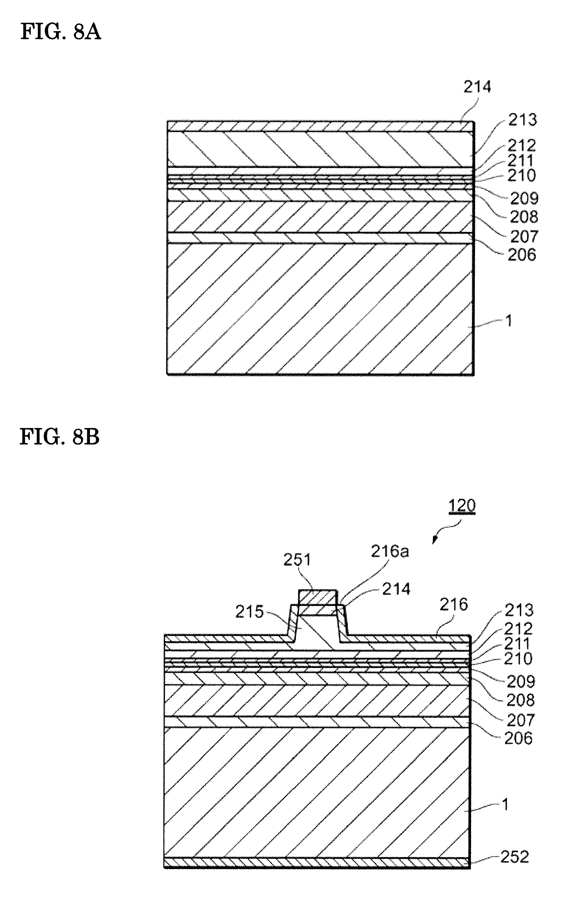

Fig. 8 is diagrams of a semiconductor device 120 involving Embodying Mode 6 of the present invention. As shown in Fig. 8B, the semiconductor device 120 involving the present embodying mode is composed of: a semiconductor laminar structure in which are formed, in order on the front side of a GaN wafer 1, an $n$-type GaN buffer layer 206, an $n$-type AlGaN cladding layer 207, an $n$-type GaN optical waveguide layer 208, an active layer 209, an undoped InGaN deterioration-preventing layer 210, a $p$-type AlGaN gap layer 211, a $p$-type GaN optical waveguide layer 212, a $p$-type AlGaN cladding layer 213, and a $p$-type GaN contact layer 214; and further, a $p$-electrode 251 on the front side of the $p$-type GaN contact layer 214, and an $n$-electrode 252 on the back side of the GaN wafer. This semiconductor device 120 functions as a laser diode (LD).

The semiconductor device 120 of the present embodying mode is fabricated by the following method for example. To begin with, for the device manufacturing step, as shown in Fig. 8A the $n$-type GaN buffer layer 206, the $n$-type AlGaN cladding layer 207, the $n$-type GaN optical waveguide layer 208, the active layer 209, the undoped AlGaN deterioration-preventing layer 210, the $p$-type AlGaN gap layer 211, the $p$-type GaN optical waveguide layer 212, the $p$-type AlGaN cladding layer 213, and the $p$-type GaN contact layer 214 are formed, in order, by MOCVD onto the front side of the GaN wafer 1. Next, an $SiO_2$ film is formed across the entire front side of the $p$-type GaN contact layer 214 by the CVD method and then is patterned photolithographically. Next, as indicated in Fig. 8B a ridge 215 is formed by etching thickness-wise to a predetermined depth into the $p$-type AlGaN cladding layer 213. The $SiO_2$ film is thereafter cleared away, and then an $SiO_2$ insulating film 216 is formed over the entire wafer surface. Next, by formation of a resist pattern and by etching, the $p$-electrode 251 is formed onto the upper surface of the $p$-type GaN contact layer alone. Thereafter forming the $n$-electrode 252 on the back side yields an LD-i.e., semiconductor device 120.

Here, to form the $SiO_2$ film methods such as vacuum deposition or sputtering method may be employed, while etching of the $SiO_2$ film may be by an RIE technique employing a fluorine-containing etchant gas.

In accordance with Embodying Mode 6 as just described, utilizing a polycrystalline-GaN-layer- incorporating GaN epitaxial wafer to fabricate a semiconductor device 120 makes it possible to produce a semiconductor device (LD) 120 in which cracking is minimal and the yield rate is superior.

Embodying Mode 7

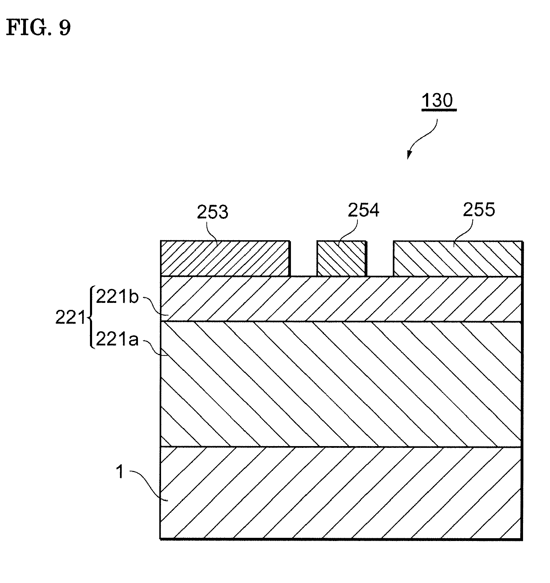

Fig. 9 is a diagram of a semiconductor device 130 involving Embodying Mode 7 of the present invention. As shown in Fig. 9, the semiconductor device 130 involving the present embodying mode is composed of: an *i*-type GaN layer 221*a* and an *i*-type AlGaN layer 221*b* formed, in order, as an at least single-lamina III-nitride semiconductor layer 221 on the front side of a GaN wafer 1; and further, on the front side of the *i*-type AlGaN layer 221*b*, a source electrode 253, a gate electrode 254, and a drain electrode 255. This semiconductor device 130 functions as a high electron mobility transistor (HEMT).

The semiconductor device 130 of the present embodying mode is fabricated by the following method for example. For the device manufacturing step, as shown in Fig. 9, the *i*-type GaN layer 221*a* and the *i*-type AlGaN layer 221*b* are grown onto the front side of the GaN wafer 1, after which the source electrode 253 and drain electrode 255 are formed onto the *i*-type-AlGaN layer 221*b* by photolithographic and lift-off processes, following which the gate electrode 254 further is formed, yielding an HEMT-i.e., semiconductor device 130.

In accordance with Embodying Mode 7 as just described, utilizing a polycrystalline-GaN-layer- incorporating GaN epitaxial wafer to fabricate a semiconductor device 130 makes it possible to produce a semiconductor device (HEMT) 130 in which cracking is minimal and the yield rate is superior.

Embodying Mode 8

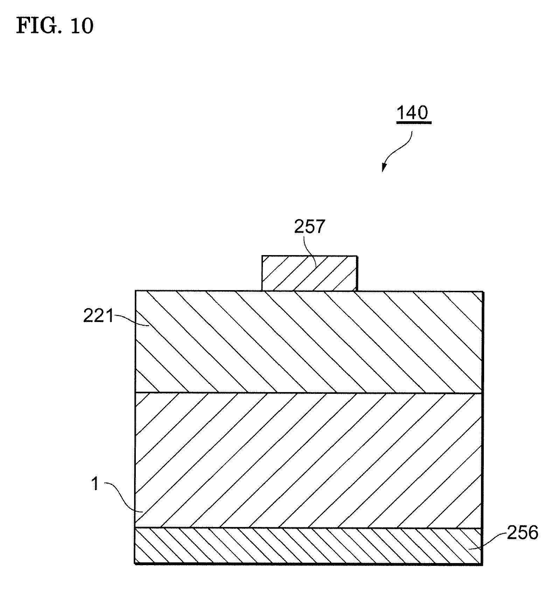

Fig. 10 is a diagram of a semiconductor device 140 involving Embodying Mode 8 of the present invention. As shown in Fig. 10, the semiconductor device 140 involving the present embodying mode includes: an *n*-type GaN layer 221 as an at least single-lamina III-nitride semiconductor layer on the front side of a GaN wafer 1, and is furnished with an ohmic electrode 256 on the back side of the GaN wafer 1. Further, a Schottky electrode 257 is furnished on the front side of the *n*-type GaN layer 221. This semiconductor device 140 functions as a Schottky diode.

The semiconductor device 140 of the present embodying mode is fabricated by the following method for example. For the device manufacturing step, as shown in Fig. 10, the *n*-type GaN layer 221 is grown, by MOCVD, onto the GaN wafer 1. Next the ohmic electrode 256 is formed across the entire back side of the GaN wafer 1. Further, the Schottky electrode 257 is formed onto the *n*-type GaN layer by photolithographic and lift-off processes. By the above, a Schottky diode-i.e., semiconductor device 140-is obtained.

In accordance with Embodying Mode 8 as just described, utilizing a polycrystalline-GaN-layer- incorporating GaN epitaxial wafer to fabricate a semiconductor device 140 makes it possible to produce a semiconductor device (Schottky diode) 140 in which cracking is minimal and the yield rate is superior.

Embodying Mode 9

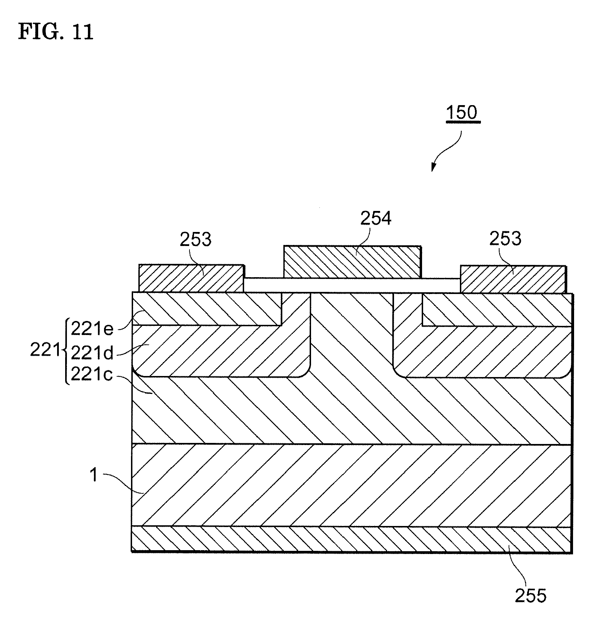

Fig. 11 is a diagram of a semiconductor device 150 involving Embodying Mode 9 of the present invention. As shown in Fig. 11, in the semiconductor device 150 involving the present embodying mode, an $n^-$-type GaN layer 221c is formed as an at least single-lamina III-nitride semiconductor layer 221 on the front side of a GaN wafer 1, and a *p*-type GaN layer 221*d* and an $n^+$-type GaN layer 221*e* are formed in regions occupying part of the upper surface of the $n^-$-type GaN layer. Further furnished are: a drain electrode 255 on the back side of the GaN wafer 1, a gate electrode 254 on the front side of the $n^-$-type GaN layer 221c, and a source electrode 253 on the front side of the $n^+$-type GaN layer 221e. This semiconductor device 150 functions as a vertical metal-insulator-semiconductor (MIS) transistor.

The semiconductor device 150 of the present embodying mode is fabricated by the following method for example. For the device manufacturing step, as shown in Fig. 11, the $n^-$-type GaN layer 221c is formed by MOCVD onto the front side of a GaN wafer 1. Subsequently, by implantation of select ions, the *p*-type GaN layer 221*d* and $n^+$-type GaN layer 221*e* are in that order formed in regions occupying part of the upper surface of the $n^-$-type GaN layer. Next, an $SiO_2$ film is employed to protect the $n^-$-type GaN layer 221c, which is then annealed to activate the implanted ions. By plasma-enhanced chemical vapor deposition (P-CVD), an $SiO_2$ film is formed as an insulating film for the vertical MIS; then by a photolithographic process and a select etching process employing buffered hydrofluoric acid, a portion of the aforementioned vertical MIS insulating film is etched, and by a lift-off process the source electrode 253 is formed on the front side of the $n^+$-type GaN layer 221e. Next, by photolithographic and lift-off processes the gate electrode 254 is formed onto the vertical MIS insulating film. Further, the drain electrode 255 is formed across the entire back side of the GaN wafer 1, yielding a vertical MIS transistor-i.e., semiconductor device 150.

In accordance with Embodying Mode 9 as just described, utilizing a polycrystalline-GaN-layer- incorporating GaN epitaxial wafer to fabricate a semiconductor device 150 makes it possible to produce a semiconductor device (vertical MIS transistor) 150 in which cracking is minimal and the yield rate is superior.

EMBODIMENTS

Below, with GaN epitaxial wafers, and semiconductor devices fabricated based on semiconductor-device manufacturing methods, involving the present invention as embodiment examples, and with semiconductor devices fabricated employing conventional monocrystalline GaN wafers as comparative examples, a further detailed description of the present invention will be made, yet the present invention is not limited to the following embodiment examples.

*Production of Wafers Used in Embodiment Examples and Comparative Examples*

Production of GaN Wafers Utilized in Embodiments 1 to 50 and Embodiments A to E

The GaN epitaxial wafer utilized in the method of above-described Embodying Mode 4 was fabricated. To begin with, MOCVD was employed to grow a GaN crystal layer (corresponding to the first GaN layer) 3 $\mu$m onto 2.5-inch (Embodiments 1 to 50) as well as 3-inch (Embodiments A to E) (0001) $c^-$ plane sapphire wafers (corresponding to the first GaN layer formation step). Thereafter the sapphire wafers onto which the GaN crystal layer had been grown were taken out of the reactor, and an SiO$_2$ film was layered onto GaN crystal layer and was patterned by a photolithographic process employing a lattice pattern with 5-$\mu$m sized windows and a 5 $\mu$m linewidth (the photographic negative of the mask pattern 60 depicted in Fig. 4). After that, GaN crystal growth employing HVPE was carried out at 1000°C to a thickness of approximately 1 $\mu$m onto the SiO$_2$ film. When the growth-bearing wafers were withdrawn and examined, GaN crystal had grown partially, wherein regions where GaN crystal had not grown could be observed in part. The wafers were once again inserted into the HVPE reactor, where they were etched by flowing an HCl gas at 800°C (corresponding to the pit formation step), and then they were taken out of the reactor and underwent SEM observation, whereupon part of the starting GaN crystal and the grown GaN crystal had been etched, with inclined GaN crystal also being observed. The wafers were once again inserted into the HVPE reactor, where at 1000°C GaN crystal was grown onto them to a thickness of approximately 300 $\mu$m (corresponding to the second GaN layer formation step), after which the wafers were taken out of the HVPE reactor. The above steps yielded GaN epitaxial wafers.
Subsequently, among the GaN epitaxial wafers, the portion with a layer consisting of GaN polycrystal were sliced from their sapphire substrates to yield polycrystalline GaN wafers.

XRD Analysis

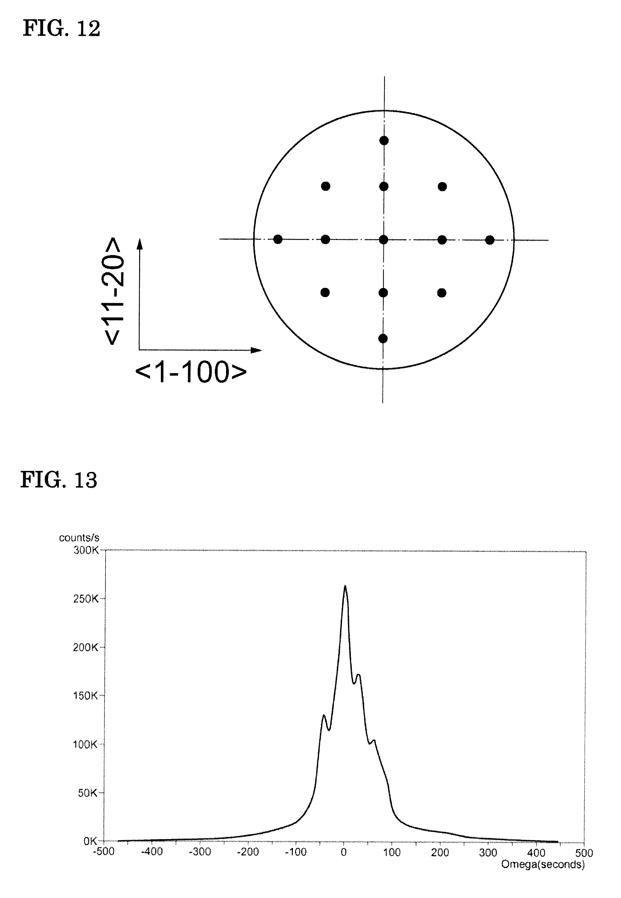

The XRD patterns of the polycrystalline GaN wafers obtained by the method detailed above were recorded, and the number of sites with crystal-peak divisions and the number of peaks were determined.
The method whereby the XRD patterns were determined will be specifically set forth using Fig. 12. A double-crystal x-ray diffractometer was employed as the analyzer, and for the analysis parameters, the slit dimensions were let be 500 $\mu$m length $\times$ 200 $\mu$m width, the x-ray beam incident orientation was let be along a <11-20> direction, and the diffraction plane was let be the (0004) plane. Fig. 12 is a diagram illustrating points for analyzing diffraction patterns from the polycrystalline GaN wafers. Analysis points were thus established in thirteen sites from the center of the GaN wafers at 10-mm spacings along a <11-20> direction and along a <1-100> direction. The diffraction patterns in these points were determined, and at each analysis point the presence of divisions in the diffraction peaks and the number of peaks were found.
Fig. 13 is an example of a diffraction pattern recorded at one of the analysis points. From the presence of divisions and the number of peaks in the thirteen places, thus obtained from the diffraction patterns recorded at each analysis point, the split peak mean count was found by the following procedure. To begin with, letting the number of analysis points where peak-splitting arose (points where the peak count was 2 or more) be $n$ sites ($n$ being a whole number from 1 to 13) and the peak counts at the analysis points where peak-splitting arose be respectively $a_1$ to $a_n$, then the number found by the following general formula (1)

$$\text{split peak mean count} = (a_1 + \ldots + a_n)/n \qquad (1)$$

was taken as the split peak mean count.
The aforedescribed numerical value was found for a plurality of polycrystalline GaN wafers to distinguish wafers to be utilized in Embodiments 1 to 50. Utilizing these polycrystalline GaN wafers of Embodiments 1 to 50 (ten wafers for each embodiment, 500 wafers total), semiconductor devices were fabricated based on each of the following semiconductor-device manufacturing methods.
As the wafers utilized in the semiconductor devices of Embodiments A through E, fifty polycrystalline GaN wafers of 3-inch size, and whose peak-split occurrence sites were one site (n = 1) and whose peak split count in the peak-split occurrence sites was 2 (making the split peak mean count 2) were readied. Utilizing these, semiconductor devices were fabricated based on each of the following semiconductor-device manufacturing methods.

Monocrystalline GaN wafers for Comparative Examples 1 through 5 and Comparative Examples A through E

Monocrystalline GaN wafers of 2.5-inch size and 400-$\mu$m thickness were used for Comparative Examples 1 through 5, and wafers of 3-inch size and 400-$\mu$m thickness for Comparative Examples A through E. These monocrystalline GaN wafers were x-ray analyzed to determine their diffraction patterns in the same manner as were the polycrystalline GaN wafers utilized in the embodiments, whereat peak-splitting did not arise in any of the analysis points.

*Semiconductor Device Testing Method*

1. Crack Test

The wafers divided into the respective embodiments / comparative examples were observed under a differential interference microscope to check for the presence of cracks. The observation zone was the entire surface of each wafer excluding a 5 mm periphery, and the observation magnification of the objective lens was set to be 20X. In instances where cracks were discovered, if there were thirty or more cracks of 100 $\mu$m or greater length, the wafer was considered to be "cracks present" and deemed a failure, and was not passed to the succeeding stage.
The crack test was conducted two times in the step of manufacturing each semiconductor device. The first time was after semiconductor layers were grown onto the wafer (in Tables I through X setting forth the results, entered as "cracking @ epi"), while the second time was after performing processes including forming an electrode on the back side of the wafer (entered as "cracking @ back lap" in Tables I through X). In Tables I through X presenting the results, the number of wafers deemed to be free of cracks (qualifying wafers) is given.

2. Device Test

An evaluation concerning the device properties of each semiconductor device fabricated in the semiconductor device manufacturing step was as follows. To begin with, to characterize the device properties of the semiconductor devices, corresponding to the comparative examples of each semiconductor device, incorporating the monocrystalline GaN wafers, determined in each case were, with their mean values and $\sigma$ being calculated: for LEDs, emission intensity; for LDs, lasing lifespan; for HEMTs, Schottky diodes, and vertical MIS transistors, "ON" resistance. On this basis the device properties of each of the semiconductor devices of the embodiments were characterized, and those having results over the value [mean - $\sigma$] for the device properties of the comparative examples were taken to be qualifying. With the devices incorporating the comparative examples, in the same way, those having results over the value [mean - $\sigma$] for the comparative-example device properties were taken to be qualifying.
Using, among the numerical values obtained from the above-described tests, the number of qualifying wafers in the two-times crack test (the number given at "cracking @ back lap" in Tables I through X) and the device-property test results (proportion of qualifying chips), the total yield rate was calculated employing the following general formula (2).

$$\frac{\text{total}}{\text{yield}} = \frac{\text{count of wafers}}{\text{qualifying in crack test}} \times \frac{\text{proportion of device-property-}}{\text{qualifying chips (\%)}} \div \tilde{1}0 \quad (2)$$

Using the method described above, tests were conducted on the following semiconductor-device embodiments and comparative examples. Details of the method manufacturing, and the results of testing, the semiconductor-devices are presented below.

*Embodiments 1 to 10; Comparative Example 1*

Embodiments 1 to 10 and Comparative Example 1 are LEDs being semiconductor device 110 involving Embodying Mode 5 of the present invention. The manufacturing method and testing method were as follows.
By MOCVD, a 5-$\mu$m thick *n*-type GaN layer, a 3-nm thick $In_{0.2}Ga_{0.8}N$ layer, a 60-nm thick $Al_{0.2}G_{a0.8}N$ layer, and a 150-nm thick *p*-type GaN layer were epitaxially grown, in that order, as an at least single-lamina III-nitride semiconductor layer onto a 2.5-inch size, 400-$\mu$m thick polycrystalline GaN wafer (in Comparative Example 1, a monocrystalline GaN wafer was used).

Epi-wafer screening was conducted by observation under a differential interference microscope to test for the presence of cracks (first-time test).

Further, a *p*-electrode of 100 nm thickness was formed on the upper surface of the *p*-type GaN layer. Next, in order to facilitate singulating the wafers into chips, the surface of the *p*-type GaN layer was adhered to a polishing holder, and then a polishing process that employed a slurry containing an SiC abrasive of 30 $\mu$m mean particle diameter was carried out to bring the thickness of the polycrystalline GaN wafers (as well as monocrystalline GaN wafer) from 400 $\mu$m down to 100 $\mu$m.

Afterwards, *n*-electrodes of 80 $\mu$m diameter $\times$ 100 nm thickness were formed in positions on the back side of the polycrystalline GaN wafers (as well as monocrystalline GaN wafer) that would become the central portions when the wafers were singulated into individual chips, and epi-wafer screening was conducted by observation under a differential interference microscope to test for the presence of cracks (second-time test). Following that, the semiconductors were singulated into individual 400 $\mu$m $\times$ 400 $\mu$m chips. By the above, LEDs involving Embodiments 1 to 10 and Comparative Example 1 were fabricated, after which the device properties were tested. The results are set forth in Table I.

Table I

| LED<br>GaN substrate size:<br>2-inch | Embodiment | | | | | | | | | | Comp. Ex. |
|---|---|---|---|---|---|---|---|---|---|---|---|
| | 1 | 2 | 3 | 4 | 5 | 6 | 7 | 8 | 9 | 10 | 1 |
| No. *n* of peak-split sites | 1 | 1 | 3 | 3 | 5 | 5 | 8 | 8 | 13 | 13 | 0 |
| Split peak mean count | 2 | 4 | 2.3 | 4.7 | 2.2 | 5.8 | 2.5 | 4.9 | 2.3 | 4.3 | 0 |
| Cracking @ epi (wafer count) | 9 | 10 | 10 | 10 | 10 | 10 | 10 | 10 | 10 | 10 | 6 |
| Cracking @ back lap (wafer count) | 7 | 7 | 8 | 8 | 9 | 9 | 9 | 10 | 10 | 10 | 3 |
| Device properties: qualifying chips (%) | 80 | 81 | 67 | 65 | 63 | 59 | 58 | 58 | 52 | 51 | 84 |
| Total yield | 56.0 | 56.7 | 53.6 | 52.0 | 56.7 | 53.1 | 52.2 | 58.0 | 52.0 | 51.0 | 25.2 |

As is evident in Table I, the "cracking @ epi" and "cracking @ back lap" wafer counts (qualifying wafer counts) for the semiconductor devices fabricated utilizing polycrystalline GaN wafers (Embodiments 1 to 10) are augmented by comparison with the semiconductor device fabricated using a monocrystalline GaN wafer (Comparative Example 1), wherein it was understood that the occurrence of cracks was controlled to a minimum. The effectiveness in controlling cracking was greater with larger number n of peak-split sites in the polycrystalline GaN wafers, with the rejects due to cracking being few. Moreover, with regard to the semiconductor device yield rate also, in which the evaluation of the device properties was taken into consideration, the yield with every one of Embodiments 1 to 10 was higher than that with Comparative Example 1.

*Embodiment A; Comparative Example A*

With the exception that, as a polycrystalline GaN wafer / a monocrystalline GaN wafer, crystals of 3-inch size were used, the LEDs that were Embodiment A and Comparative Example A were fabricated, and the device properties evaluated, by the same methods as for Embodiments 1 to 10 and Comparative Example 1. The results are set forth in Table II.

Table II

| LED | Embodiment | Comp. Ex. |
|---|---|---|
| GaN substrate size: 3-inch | A | A |
| No. n of peak-split sites | 1 | 0 |

(continued)

| LED | Embodiment | Comp. Ex. |
|---|---|---|
| GaN substrate size: 3-inch | A | A |
| Split peak mean count | 2 | 0 |
| Cracking @ epi (wafer count) | 9 | 3 |
| Cracking @ back lap (wafer count) | 7 | 2 |
| Device properties: qualifying chips (%) | 85 | 82 |
| Total yield | 59.5 | 16.4 |

As is evident in Table II, the "cracking @ epi" and "cracking @ back lap" wafer counts (qualifying wafer counts) for the semiconductor devices fabricated utilizing a polycrystalline GaN wafer (Embodiment A) are augmented by comparison with the semiconductor device fabricated using a monocrystalline GaN wafer (Comparative Example A), wherein it was understood that the occurrence of cracks was controlled to a minimum. It was thereby confirmed that the crack-inhibiting effectiveness resulting from the polycrystalline GaN wafer does not depend on the wafer size.

*Embodiments 11 to 20; Comparative Example 2*

Embodiments 11 to 20 and Comparative Example 2 are LDs being semiconductor device 120 involving Embodying Mode 6 of the present invention. The manufacturing method and testing method were as follows.

To begin with, by MOCVD, onto 2-inch size, 400-$\mu$m thick polycrystalline GaN wafers (in Comparative Example 2, a monocrystalline GaN wafer was used),

as an at least single-lamina III-nitride semiconductor layer

an Si-doped, *n*-type GaN buffer layer of 0.05 $\mu$m thickness,

an Si-doped, *n*-type $Al_{0.08}a_{0.92}N$ cladding layer of 1.0 $\mu$m thickness,

an active layer of a multiquantum-well structure in which

an Si-doped, *n*-type GaN optical waveguide layer of 0.1 $\mu$m thickness, an undoped $In_{0.15}Ga_{0.85}N$ layer of 3 nm thickness, and an $In_{0.03}Ga_{0.97}N$ layer of 6 nm thickness were repeated five times,

an undoped $Al_{0.2}Ga_{0.8}N$ deterioration-preventing layer of 0.01 $\mu$m thickness,

a magnesium (Mg)-doped *p*-type $Al_{0.2}Ga_{0.8}N$ gap layer of 10 nm thickness,

an Mg-doped *p*-type GaN optical waveguide layer of 0.1 $\mu$m thickness,

an Mg-doped *p*-type $Al_{0.08}Ga_{0.92}N$ cladding layer of 0.3 $\mu$m thickness; and an Mg-doped *p*-type GaN contact layer were, in that order, grown epitaxially, after which the polycrystalline GaN wafers (as well as the monocrystalline GaN wafer) were taken out of the MOCVD reactor.

These epi-wafers were tested and screened for the presence of cracks by observation under a differential interference microscope (first-time test).

Subsequently, an $SiO_2$ film of 0.1 $\mu$m thickness was formed by CVD across the entire *p*-type GaN contact layer, and then a pattern corresponding to the shape of a ridge section was lithographically formed onto the $SiO_2$ film.

Next, with the $SiO_2$ film as mask, a ridge extending in a <1-100> direction was formed by etching thickness-wise to a predetermined depth into the *p*-type AlGaN cladding layer, by the RIE method. The width of the ridge was 2 $\mu$m. A chlorine-based gas was employed as the RIE etchant gas.

Next, the $SiO_2$ film employed as an etching mask was removed by being etched away, and then CVD was employed to deposit an $SiO_2$ insulating film of 0.3 $\mu$m thickness across the entire wafer. Subsequently, by lithography a resist pattern was formed covering the surface of the insulating film in a region excluding the region for forming the *p*-electrode. Next, with the resist pattern as a mask, an opening was formed by etching the insulating film.

Following that, with the resist pattern left intact, a *p*-electrode was formed by vacuum deposition across the entire wafer, after which the resist was removed together with the p- electrode material where formed onto the resist pattern, to form a *p*-electrode on the *p*-type GaN contact layer alone. In order to facilitate singulating the wafers into chips, the surface of the *p*-type GaN layer was adhered to a polishing holder, and then a polishing process that employed a slurry containing an SiC abrasive of 30 $\mu$m mean particle diameter was carried out to bring the thickness of the GaN wafers from 400 $\mu$m down to 100 $\mu$m.

Next, an *n*-electrode was formed on the back side of the polycrystalline GaN wafers (as well as the monocrystalline GaN wafer). Thereafter, epi-wafer screening was conducted by observation under a differential interference microscope to test for the presence of cracks (second-time test).

Thereafter, along the contour lines of the electronic element regions, scribing on the polycrystalline GaN wafers (as well as the monocrystalline GaN wafer) onto which a laser structure had been formed as described above was carried out with cleaving, to process them into laser bars and form both cavity endfaces. Next, endface coating was implemented on the cavity endfaces, after which scribing, with cleavages, of the laser bars was again performed, rendering them into chips. By the above, LDs involving Embodiments 11 to 20 and Comparative Example 2 were fabricated, after which the device properties were tested. The results are set forth in Table III.

Table III

| LD GaN substrate size: 2-inch | Embodiment | | | | | | | | | | Comp. Ex. |
|---|---|---|---|---|---|---|---|---|---|---|---|
| | 11 | 12 | 13 | 14 | 15 | 16 | 17 | 18 | 19 | 20 | 2 |
| No. $n$ of peak-split sites | 1 | 1 | 3 | 4 | 5 | 5 | 7 | 8 | 10 | 13 | 0 |
| Split peak mean count | 2 | 5 | 2.7 | 4.3 | 2.6 | 4.8 | 2.3 | 4.5 | 4.8 | 2.3 | 0 |
| Cracking @ epi (wafer count) | 8 | 8 | 8 | 8 | 9 | 9 | 9 | 10 | 10 | 10 | 4 |
| Cracking @ back lap (wafer count) | 6 | 7 | 8 | 8 | 8 | 9 | 10 | 10 | 10 | 10 | 2 |
| Device properties: qualifying chips (%) | 58 | 60 | 47 | 45 | 44 | 40 | 38 | 38 | 38 | 32 | 46 |
| Total yield | 34.8 | 42.0 | 37.6 | 36.0 | 35.2 | 36.0 | 38.0 | 38.0 | 38.0 | 32.0 | 9.2 |

As is evident in Table III, the "cracking @ epi" and "cracking @ back lap" wafer counts (qualifying wafer counts) for the semiconductor devices fabricated utilizing polycrystalline GaN wafers (Embodiments 11 to 20) are augmented by comparison with the semiconductor device fabricated using a monocrystalline GaN wafer (Comparative Example 2), wherein it was understood that the occurrence of cracks was controlled to a minimum. The effectiveness in controlling cracking was greater with larger number n of peak-split sites in the polycrystalline GaN wafers, with the rejects due to cracking being few. Moreover, with regard to the semiconductor device yield rate also, in which the evaluation of the device properties was taken into consideration, the yield with every one of Embodiments 11 to 20 was higher than that with Comparative Example 2.

Embodiment B; Comparative Example B

With the exception that, as a polycrystalline GaN wafer / a monocrystalline GaN wafer, crystals of 3-inch size were used, the LDs that were Embodiment B and Comparative Example B were fabricated, and the device properties evaluated, by the same methods as for Embodiments 11 to 20 and Comparative Example 1. The results are set forth in Table IV.

Table IV

| LD GaN substrate size: 3-inch | Embodiment | Comp. Ex. |
|---|---|---|
| | B | B |
| No. n of peak-split sites | 1 | 0 |
| Split peak mean count | 2 | 0 |
| Cracking @ epi (wafer count) | 8 | 3 |
| Cracking @ back lap (wafer count) | 7 | 1 |
| Device properties: qualifying chips (%) | 59 | 45 |
| Total yield | 41.3 | 4.5 |

As is evident in Table IV, the "cracking @ epi" and "cracking @ back lap" wafer counts (qualifying wafer counts) for the semiconductor devices fabricated utilizing a polycrystalline GaN wafer (Embodiment B) are augmented by comparison with the semiconductor device fabricated using a monocrystalline GaN wafer (Comparative Example B), wherein it was understood that the occurrence of cracks was controlled to a minimum. It was thereby confirmed that the crack-inhibiting effectiveness resulting from the polycrystalline GaN wafer does not depend on the wafer size.

*Embodiments 21 to 30; Comparative Example 3*

Embodiments 21 to 30 and Comparative Example 3 are HEMTs being semiconductor device 130 involving Embodying Mode 7 of the present invention. The manufacturing method and testing method were as follows.

By MOCVD, a 3-$\mu$m thick *i*-type GaN layer and a 30-nm thick *i*-type $Al_{0.15}Ga_{0.85}N$ layer were grown as an at least single-lamina III-nitride semiconductor layer onto a 2-inch size, 400-$\mu$m thick polycrystalline GaN wafer (in Comparative Example 3, a monocrystalline GaN wafer was used).

Epi-wafer screening was conducted by observation under a differential interference microscope to test for the presence of cracks (first-time test).

Next, by photolithographic and lift-off processes, onto the *i*-type $Al_{0.15}Ga_{0.85}N$ layer as a source electrode and a drain electrode, respective Ti layer (50 nm thickness) / Al layer (100 nm thickness) / Ti layer (20 nm thickness) / Au layer (200 nm thickness) laminar composites were formed by heating the layers at 800°C for 30 seconds to alloy them. Further, an Au layer of 300 nm thickness was formed as a gate electrode. The gate length was 2 $\mu$m, and the gate width, 150 $\mu$m.

In order to facilitate singulating the wafers into chips, the surface of the *p*-type GaN layer was adhered to a polishing holder, and then a polishing process that employed a slurry containing an SiC abrasive of 30 $\mu$m mean particle diameter was carried out to bring the thickness of the polycrystalline GaN wafers (as well as the monocrystalline GaN wafer) from 400 $\mu$m down to 100 $\mu$m. Epi-wafer screening was conducted by observation under a differential interference microscope to test for the presence of cracks (second-time test).

Following that, the semiconductors constituted by the above-described polycrystalline GaN wafers (as well as the monocrystalline GaN wafer) and III-nitride semiconductor layers were singulated into individual 400 $\mu$m $\times$ 400 $\mu$m chips. By the above, HEMTs involving Embodiments 21 to 30 and Comparative Example 3 were fabricated, after which the device properties were tested. The results are set forth in Table V.

Table V

| HEMT GaN substrate size: 2-inch | Embodiment | | | | | | | | | | Comp. Ex. |
|---|---|---|---|---|---|---|---|---|---|---|---|
| | 21 | 22 | 23 | 24 | 25 | 26 | 27 | 28 | 29 | 30 | 3 |
| No. *n* of peak-split sites | 1 | 1 | 3 | 3 | 5 | 5 | 6 | 8 | 9 | 13 | 0 |
| Split peak mean count | 2 | 4 | 3.3 | 4.7 | 2.2 | 5.4 | 2.5 | 4.8 | 5.9 | 3.7 | 0 |
| Cracking @ epi (wafer count) | 9 | 10 | 10 | 10 | 10 | 10 | 10 | 10 | 10 | 10 | 5 |
| Cracking @ back lap (wafer count) | 8 | 8 | 8 | 8 | 9 | 10 | 10 | 10 | 10 | 10 | 3 |
| Device properties: qualifying chips (%) | 77 | 78 | 73 | 70 | 73 | 69 | 66 | 68 | 65 | 62 | 80 |
| Total yield | 61.6 | 62.4 | 58.4 | 56.0 | 65.7 | 69.0 | 66.0 | 68.0 | 65.0 | 62.0 | 24.0 |

As is evident in Table V, the "cracking @ epi" and "cracking @ back lap" wafer counts (qualifying wafer counts) for the semiconductor devices fabricated utilizing polycrystalline GaN wafers (Embodiments 21 to 30) are augmented by comparison with the semiconductor device fabricated using a monocrystalline GaN wafer (Comparative Example 3), wherein it was understood that the occurrence of cracks was controlled to a minimum. The effectiveness in controlling cracking was greater with larger number n of peak-split sites in the polycrystalline GaN wafers, with the rejects due to cracking being few. Moreover, with regard to the semiconductor device yield rate also, in which the evaluation of the device properties was taken into consideration, the yield with every one of Embodiments 21 to 30 was higher than that with Comparative Example 3.

*Embodiment C; Comparative Example C*

With the exception that, as a polycrystalline GaN wafer / a monocrystalline GaN wafer, crystals of 3-inch size were used, the HEMTs that were Embodiment C and Comparative Example C were fabricated, and the device properties evaluated, by the same methods as for Embodiments 21 to 30 and Comparative Example 3. The results are set forth in Table VI.

Table VI

| HEMT | Embodiment | Comp. Ex. |
|---|---|---|
| GaN substrate size: 3-inch | C | C |
| No. n of peak-split sites | 1 | 0 |
| Split peak mean count | 2 | 0 |
| Cracking @ epi (wafer count) | 8 | 3 |
| Cracking @ back lap (wafer count) | 7 | 2 |
| Device properties: qualifying chips (%) | 75 | 78 |
| Total yield | 52.5 | 15.6 |

As is evident in Table VI, the "cracking @ epi" and "cracking @ back lap" wafer counts (qualifying wafer counts) for the semiconductor device fabricated utilizing a polycrystalline GaN wafer (Embodiment C) are augmented by comparison with the semiconductor device fabricated using a monocrystalline GaN wafer (Comparative Example C), wherein it was understood that the occurrence of cracks was controlled to a minimum. It was thereby confirmed that the crack-inhibiting effectiveness resulting from the polycrystalline GaN wafer does not depend on the wafer size.

*Embodiments 31 to 40; Comparative Example 4*

Embodiments 31 to 40 and Comparative Example 4 are Schottky diodes being semiconductor device 140 involving Embodying Mode 8 of the present invention. The manufacturing method and testing method were as follows.

By MOCVD, an *n*-type GaN layer (whose electron density was $1 \times 10^{16}$ cm$^{-3}$) of 5 $\mu$m thickness was grown as an at least single-lamina III-nitride semiconductor layer onto a 2-inch size, 400-$\mu$m thick polycrystalline GaN wafer (in Comparative Example 4, a monocrystalline GaN wafer was used). Epi-wafer screening was conducted by observing the wafers under a differential interference microscope to test for the presence of cracks (first-time test).

Next, as an ohmic electrode across the entire back side of the polycrystallineline GaN wafers (as well as monocyrstalline GaN wafer), a Ti layer (50 nm thickness) / Al layer (100 nm thickness) / Ti layer (20 nm thickness) / Au layer (200 nm thickness) laminar composite was formed by heating the layers at 800°C for 30 seconds to alloy them. Furthermore, by photolithographic and lift-off processes, an Au layer of diameter 200 $\mu$m $\times$ thickness 300 nm was formed onto the *n*-type GaN layer as a Schottky electrode.

In order to facilitate singulating the wafers into chips, the surface of the *p*-type GaN layer was adhered to a polishing holder, and then a polishing process that employed a slurry containing an SiC abrasive of 30 $\mu$m mean particle diameter was carried out to bring the thickness of the polycrystalline GaN wafers (as well as the monocrystalline GaN wafer) from 400 $\mu$m down to 100 $\mu$m. Thereafter epi-wafer screening was conducted by observation under a differential interference microscope to test for the presence of cracks (second-time test).

Following that, the semiconductors constituted by the above-described polycrystalline GaN wafers (as well as the monocrystalline GaN wafer) and III-nitride semiconductor layers were singulated into individual 400 $\mu$m $\times$ 400 $\mu$m chips. By the above, Schottky diodes involving Embodiments 31 to 40 and Comparative Example 4 were fabricated, after which the device properties were tested. The results are set forth in Table VII.

Table VII

| Schottky diode GaN substrate size: 2-inch | Embodiment | | | | | | | | | | Comp. Ex. |
|---|---|---|---|---|---|---|---|---|---|---|---|
| | 31 | 32 | 33 | 34 | 35 | 36 | 37 | 38 | 39 | 40 | 4 |
| No. $n$ of peak-split sites | 1 | 2 | 3 | 3 | 5 | 7 | 8 | 10 | 11 | 13 | 0 |
| Split peak mean count | 2 | 4 | 2.3 | 4.7 | 2.4 | 5.7 | 2.5 | 4.8 | 4.9 | 2.3 | 0 |
| Cracking @ epi (wafer count) | 9 | 10 | 10 | 10 | 10 | 10 | 10 | 10 | 10 | 10 | 7 |
| Cracking @ back lap (wafer count) | 7 | 7 | 8 | 8 | 8 | 9 | 9 | 10 | 10 | 10 | 6 |
| Device properties: qualifying chips (%) | 80 | 83 | 78 | 78 | 77 | 71 | 71 | 73 | 68 | 65 | 75 |
| Total yield | 56.0 | 58.1 | 62.4 | 62.4 | 61.6 | 63.9 | 63.9 | 73.0 | 68.0 | 65.0 | 45.0 |

As is evident in Table VII, the "cracking @ epi" and "cracking @ back lap" wafer counts (qualifying wafer counts) for the semiconductor devices fabricated utilizing polycrystalline GaN wafers (Embodiments 31 to 40) are augmented by comparison with the semiconductor device fabricated using a monocrystalline GaN wafer (Comparative Example 4), wherein it was understood that the occurrence of cracks was controlled to a minimum. The effectiveness in controlling cracking was greater with larger number n of peak-split sites in the polycrystalline GaN wafers, with the rejects due to cracking being few. Moreover, with regard to the semiconductor device yield rate also, in which the evaluation of the device properties was taken into consideration, the yield with every one of Embodiments 31 to 40 was higher than that with Comparative Example 4.

*Embodiment D; Comparative Example D*

With the exception that, as a polycrystalline GaN wafer / a monocrystalline GaN wafer, crystals of 3-inch size were used, the Schottky diodes that were Embodiment D and Comparative Example D were fabricated, and the device properties evaluated, by the same methods as for Embodiments 31 to 40 and Comparative Example 4. The results are set forth in Table VIII.

Table VIII

| Schottky diode GaN substrate size: 3-inch | Embodiment | Comp. Ex. |
|---|---|---|
| | D | D |
| No. n of peak-split sites | 1 | 0 |
| Split peak mean count | 2 | 0 |
| Cracking @ epi (wafer count) | 8 | 5 |
| Cracking @ back lap (wafer count) | 7 | 4 |
| Device properties: qualifying chips (%) | 82 | 77 |
| Total yield | 57.4 | 30.8 |

As is evident in Table VIII, the "cracking @ epi" and "cracking @ back lap" wafer counts (qualifying wafer counts) for the semiconductor device fabricated utilizing a polycrystalline GaN wafer (Embodiment D) are augmented by comparison with the semiconductor device fabricated using a monocrystalline GaN wafer (Comparative Example D), wherein it was understood that the occurrence of cracks was controlled to a minimum. It was thereby confirmed that the crack-inhibiting effectiveness resulting from the polycrystalline GaN wafer does not depend on the wafer size.

*Embodiments 41 to 50; Comparative Example 5*

Embodiments 41 to 50 and Comparative Example 5 are vertical MIS transistors being semiconductor device 150 involving Embodying Mode 9 of the present invention. The manufacturing method and testing method were as follows.

By MOCVD, an *n*-type GaN layer (whose electron density was $1 \times 10^{16}$ cm$^{-3}$) of 5 $\mu$m thickness was grown as an at least single-lamina III-nitride semiconductor layer onto a 2-inch size, 400-$\mu$m thick polycrystalline GaN wafer (in Comparative Example 5, a monocrystalline GaN wafer was used). Epi-wafer screening was conducted by observing the wafers under a differential interference microscope to test for the presence of cracks (first-time test).

Next, by implantation of select ions, a *p*-type GaN layer and an *n$^+$*-type GaN layer were formed. Herein, the *p*-type GaN layer was formed by Mg-ion implantation, while the *n$^+$*-type GaN layer was formed by Si-ion implantation. Next, a 300-nm thick SiO$_2$ film was formed as a protective film on the III-nitride semiconductor layer, which was then annealed at 1250°C for 30 seconds to activate the implanted ions. Following that the aforedescribed protective film was stripped off with hydrofluoric acid, and then an SiO$_2$ film of 50 nm thickness was formed by plasma-enhanced chemical vapor deposition (P-CVD) as an MIS insulating film.

Next, by a photolithographic process and a select etching process employing buffered hydrofluoric acid, a portion of the aforementioned MIS insulating film was etched, and by a lift-off process, onto the etched region as a source electrode a Ti layer (50 nm thickness) / Al layer (100 nm thickness) / Ti layer (20 nm thickness) / Au layer (200 nm thickness) laminar composite was formed by heating the layers at 800°C for 30 seconds to alloy them. Following that, by photolithographic and lift-off processes an Al layer of 300 nm thickness was formed as a gate electrode onto the MIS insulating film, creating an MIS structure.

In order to facilitate singulating the wafers into chips, the surface of the *p*-type GaN layer was adhered to a polishing holder, and then a polishing process that employed a slurry containing an SiC abrasive of 30 $\mu$m mean particle diameter was carried out to bring the thickness of the polycrystalline GaN wafers (as well as the monocrystalline GaN wafer) from 400 $\mu$m down to 100 $\mu$m. Thereafter epi-wafer screening was conducted by observation under a differential interference microscope to test for the presence of cracks (second-time test).

Next, the semiconductors constituted by the above-described polycrystalline GaN wafers (as well as the monocrystalline GaN wafer) and III-nitride semiconductor layers were singulated into individual 400 $\mu$m × 400 $\mu$m chips. Across the entire back side of each singulated chip's polycrystalline GaN wafer (monocrystalline GaN wafer), as a drain electrode a Ti layer (50 nm thickness) / Al layer (100 nm thickness) / Ti layer (20 nm thickness) / Au layer (200 nm thickness) laminar composite was formed by heating the layers at 800°C for 30 seconds to alloy them. By the above, vertical MIS transistors involving Embodiments 41 to 50 and Comparative Example 5 were fabricated, after which the device properties were tested. The results are set forth in Table IX.

Table IX

| Vertical MIS transistor | Embodiment | | | | | | | | | | Comp . Ex. |
|---|---|---|---|---|---|---|---|---|---|---|---|
| GaN substrate size: 2-inch | 41 | 42 | 43 | 44 | 45 | 46 | 47 | 48 | 49 | 50 | 5 |
| No. *n* of peak-split sites | 1 | 2 | 3 | 4 | 5 | 6 | 8 | 10 | 12 | 12 | 0 |
| Split peak mean count | 2 | 3.5 | 4.3 | 2.5 | 2.6 | 6 | 2.5 | 4.8 | 2.1 | 4.1 | 0 |
| Cracking @ epi (wafer count) | 9 | 9 | 10 | 10 | 10 | 10 | 10 | 10 | 10 | 10 | 7 |
| Cracking @ back lap (wafer count) | 7 | 7 | 8 | 8 | 8 | 9 | 9 | 10 | 10 | 10 | 5 |
| Device properties: qualifying chips (%) | 83 | 85 | 81 | 77 | 74 | 74 | 77 | 71 | 73 | 71 | 78 |
| Total yield | 58.1 | 59.5 | 64.8 | 61.6 | 59.2 | 66.6 | 69.3 | 71.0 | 73.0 | 71.0 | 39.0 |

As is evident in Table IX, the "cracking @ epi" and "cracking @ back lap" wafer counts (qualifying wafer counts) for the semiconductor devices fabricated utilizing polycrystalline GaN wafers (Embodiments 41 to 50) are augmented by comparison with the semiconductor device fabricated using a monocrystalline GaN wafer (Comparative Example 5), wherein it was understood that the occurrence of cracks was controlled to a minimum. The effectiveness in controlling cracking was greater with larger number n of peak-split sites in the polycrystalline GaN wafers, with the rejects due to cracking being few. Moreover, with regard to the semiconductor device yield rate also,
in which the evaluation of the device properties was taken into consideration, the yield with every one of Embodiments 41 to 50 was higher than that with Comparative Example 5.

*Embodiment E; Comparative Example E*

With the exception that, as a polycrystalline GaN wafer / a monocrystalline GaN wafer, crystals of 3-inch size were used, the vertical MIS transistors that were Embodiment E and Comparative Example E were fabricated, and the device properties evaluated, by the same methods as for Embodiments 41 to 50 and Comparative Example 5. The results are set forth in Table X.
Table X

| Vertical MIS transistor | Embodiment | Comp. Ex. |
|---|---|---|
| GaN substrate size: 3-inch | E | E |
| No. n of peak-split sites | 1 | 0 |
| Split peak mean count | 2 | 0 |
| Cracking @ epi (wafer count) | 8 | 5 |
| Cracking @ back lap (wafer count) | 7 | 4 |
| Device properties: qualifying chips (%) | 81 | 75 |
| Total yield | 56.7 | 30.0 |

As is evident in Table X, the "cracking @ epi" and "cracking @ back lap" wafer counts (qualifying wafer counts) for the semiconductor device fabricated utilizing a polycrystalline GaN wafer (Embodiment E) are augmented by comparison with the semiconductor device fabricated using a monocrystalline GaN wafer (Comparative Example E), wherein it was understood that the occurrence of cracks was controlled to a minimum. It was thereby confirmed that the crack-inhibiting effectiveness resulting from the polycrystalline GaN wafer does not depend on the wafer size.

**Claims**

1. A GaN epitaxial wafer manufacturing method including:

   a first GaN layer formation step of epitaxially growing a first GaN layer onto a substrate;
   a pit formation step, following said first GaN layer formation step, of forming pits in the front side of the substrate; and
   a second GaN layer formation step, following said pit-formation step, of epitaxially growing a second GaN layer onto the first GaN layer.

2. A GaN epitaxial wafer manufacturing method as set forth in claim 1, including a mask-layer formation step, prior to said first GaN layer formation step, of patterning a mask layer onto the front side of the substrate.

3. A GaN epitaxial wafer manufacturing method as set forth in claim 1 or 2, wherein the substrate is constituted by a single layer.

4. A GaN epitaxial wafer manufacturing method as set forth in claim 1 or 2, wherein:

   the substrate is constituted by a plurality of layers; and
   in said pit formation step the pits are formed on the uppermost layer of the substrate.

5. A semiconductor device manufacturing method, including:

a first GaN layer formation step of epitaxially growing a first GaN layer onto a substrate;

a pit formation step, following said first GaN layer formation step, of forming pits in the front side of the substrate;

a second GaN layer formation step, following said pit-formation step, of epitaxially growing a second GaN layer onto the first GaN layer to fabricate a GaN epitaxial wafer; and

a device manufacturing step of utilizing the GaN epitaxial wafer to fabricate a semiconductor device.

6. A semiconductor device manufacturing method as set forth in claim 5, including a mask-layer formation step, prior to said first GaN layer formation step, of patterning a mask layer onto the front side of the substrate.

7. A semiconductor device manufacturing method as set forth in claim 5 or 6, wherein the substrate is constituted by a single layer.

8. A semiconductor device manufacturing method as set forth in claim 5 or 6, wherein:

the substrate is constituted by a plurality of layers; and

in said pit formation step the pits are formed on the uppermost layer of the substrate.

9. A semiconductor device manufacturing method as set forth in any of claims 5 through 8, wherein for said device manufacturing step, a GaN wafer obtained by removing the substrate from the GaN epitaxial wafer is utilized to fabricate the semiconductor device.

10. A GaN epitaxial wafer furnished with:

a substrate having pits in the major surface; and

a polycrystalline GaN layer layered onto the major surface.

11. A GaN epitaxial wafer as set forth in claim 10, including a mask layer, disposed in between said substrate and said polycrystalline GaN layer.

12. A GaN epitaxial wafer as set forth in claim 10 or 11, wherein said substrate is constituted by a single layer.

13. A GaN epitaxial wafer as set forth in claim 10 or 11, wherein:

said substrate is constituted by a plurality of layers; and

the uppermost layer of the substrate has said pits.

14. A semiconductor device **characterized in** being furnished with:

a substrate having pits in its major surface;

a GaN epitaxial wafer having a polycrystalline GaN layer layered onto said major surface; and

a semiconductor layer layered onto said polycrystalline GaN layer on said GaN epitaxial wafer.

FIG. 1A

10

FIG. 1B

11

10

FIG. 1C

11a

10a

10

FIG. 1D

51

12

11a

10a

10

FIG. 2A

FIG. 2B

FIG. 3A

FIG. 3B

FIG. 3C

FIG. 3D

FIG. 4

FIG. 5A

FIG. 5B

FIG. 5C

FIG. 5D

FIG. 6A

FIG. 6B

FIG. 6C

FIG. 6D

FIG. 7

FIG. 8A

FIG. 8B

FIG. 9

FIG. 10

FIG. 11

FIG. 12

FIG. 13

## INTERNATIONAL SEARCH REPORT

| | International application No. |
|---|---|
| | PCT/JP2008/066945 |

**A. CLASSIFICATION OF SUBJECT MATTER**
*C30B29/38*(2006.01)i, *C30B25/18*(2006.01)i, *H01L21/205*(2006.01)i, *H01S5/323* (2006.01)i, *H01S5/343*(2006.01)i

According to International Patent Classification (IPC) or to both national classification and IPC

**B. FIELDS SEARCHED**

Minimum documentation searched (classification system followed by classification symbols)
C30B29/38, C30B25/18, H01L21/205, H01S5/323, H01S5/343

Documentation searched other than minimum documentation to the extent that such documents are included in the fields searched
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br><br>A | JP 2001-122693 A (NEC Corp.),<br>08 May, 2001 (08.05.01),<br>Claims; Par. Nos. [0046] to [0047], [0079];<br>examples; Fig. 1<br>& US 2003/0207125 A1   & DE 10051632 A<br>& TW 480705 B     & KR 10-2001-0051169 A<br>& CN 1303131 A | 1,3-5,7-10,<br>12-14<br>2,6,11 |
| X<br><br>A | JP 2007-106666 A (Samsung Corning Co., Ltd.),<br>26 April, 2007 (26.04.07),<br>Claims; Figs. 1A to 1F<br>& US 2007/0082465 A1   & KR 10-0707166 B1 | 1,3,5,7,9,<br>10,12,14<br>2,4,6,8,11,<br>13 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>26 November, 2008 (26.11.08) | Date of mailing of the international search report<br>09 December, 2008 (09.12.08) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2008/066945

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2005-213075 A  (Sumitomo Electric Industries, Ltd.), 11 August, 2005 (11.08.05), Examples; Fig. 1 (Family: none) | 1-14 |

Form PCT/ISA/210 (continuation of second sheet) (April 2007)

EP 2 199 436 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004284831 A